# EUROPEAN PATENT APPLICATION

(11) **EP 3 163 641 A1**
(43) Date of publication of application: **03.05.2017**
(21) Application number: 15811571.7
(22) Date of filing: 11.06.2015
(51) Int. Cl.: H01L 41/319, C23C 14/08, C23C 14/34, H01L 41/047, H01L 41/29, H01L 41/316

(54) **PZT THIN FILM LAMINATE AND METHOD FOR PRODUCING PZT THIN FILM LAMINATE**

(30) Priority: 24.06.2014 JP 2014128856
(71) Applicant: ULVAC, Inc., Chigasaki-shi, Kanagawa 253-8543 (JP)
(72) Inventor: HIROSE, Mitsutaka, Chigasaki-shi Kanagawa 253-8543 (JP); KOBAYASHI, Hiroki, Chigasaki-shi Kanagawa 253-8543 (JP); HENMI, Mitsunori, Chigasaki-shi Kanagawa 2538543 (JP); TSUKAGOSHI, Kazuya, Chigasaki-shi Kanagawa 253-8543 (JP); TSUYUKI, Tatsuro, Chigasaki-shi Kanagawa 253-8543 (JP); KIMURA, Isamu, Chigasaki-shi Kanagawa 253-8543 (JP); SUU, Koukou, Chigasaki-shi Kanagawa 253-8543 (JP)
(74) Representative: Körber, Martin Hans
(86) International application number: PCT/JP2015/066847
(87) International publication number: WO 2015/198882

(57) **Abstract**

The present invention provides a technology for preventing the generation of a pyrochlore phase, which is an impurity phase, in forming a PZT thin film by sputtering, without using a conventional seed layer. The present invention provides a PZT thin film laminate including: a Si substrate 10; a TiOx layer 4 serving as a platinum-adhesion layer on the Si substrate 10; a Pt electrode layer 5 on the TiOx layer 4; a Ti thin film layer 6 on the Pt electrode layer 5; and a PZT thin film layer 7 on the Ti thin film layer 6. The Ti thin film layer 6 can have a thickness of 1 nm or more and 10 nm or less.

## Description

### Technical Field

The present invention generally relates to a technology for manufacturing a PZT thin film laminate using lead zirconate titanate (PZT).

### Background Art

Thin films containing lead zirconate titanate (Pb(Zr,Ti)O₃), or PZT, having excellent piezoelectric properties and ferroelectricity, are used in the application of nonvolatile memories (FeRAM) by taking advantage of their ferroelectricity.

Furthermore, integration with the MEMS technology in recent years has put MEMS piezoelectric elements to practical use. The MEMS piezoelectric elements are widely applied to, for example, ink-jet heads (actuators), angular velocity sensors and gyro sensors, as main devices.

The PZT thin films have various characteristics, which are significantly influenced by crystal orientation properties.

The PZT thin films are known to have different physical constants depending on the orientation direction. Especially in a tetragonal system, high piezoelectric properties and ferroelectricity are exhibited by obtaining a c-axis (001) orientation parallel to a polarization axis.

Furthermore, it has recently become apparent that since rotation of an inner region (domain) exhibiting ferroelectricity significantly contributes to piezoelectric properties, an a-axis (100) orthogonal to the polarization axis rotates by 90° under a high electric field to thereby provide higher piezoelectric properties than those for the c-axis single orientation.

In this manner, the characteristics of the PZT thin films are significantly influenced by crystal orientation properties, and the control thereof has become a significant challenge.

The present inventors have conducted studies on film-forming conditions for the PZT thin films and optimization of a seed layer for the purpose of controlling the orientation of a PZT film formed on an Si substrate having a diameter of 8 inches, and successfully achieved the orientation control.

However, there are still many uncertainties about the orientation mechanism of the PZT thin films, and clarification thereof is urgently needed.

Another factor that makes PZT film formation difficult is the generation of a pyrochlore phase, which is an impurity phase, during the formation of the PZT film.

More specifically, the pyrochlore phase is paraelectric, and thus gives rise to deterioration of the dielectric constant and piezoelectric properties of the PZT thin film.

Accordingly, how to obtain a PZT thin film including a perovskite single phase is also an important technology in thin-film formation.

On the other hand, in experiments using a perovskite oxide as a seed layer, no generation of a pyrochlore phase was observed. Also, there was obtained epitaxy in which the orientation of the seed layer and the orientation of PZT were identical.

In this case, although it is possible to effect orientation by the introduction of a seed layer (buffer layer), various problems exist.

For example, although a single orientation of the seed layer itself is necessary for the introduction of the seed layer, there is a problem in that a single orientation is difficult to achieve, and a (110) plane orientation or other orientations can thus be mixed to some extent.

### Citation List

### Patent Literature

Patent Literature 1: International Publication No. 2012/046705
Patent Literature 2: International Publication No. 2012/046706

### Summary of Invention

### Technical Problem

The present invention has been developed to solve such conventional technical problems. An object of the present invention is to provide a technology for preventing the generation of a pyrochlore phase, which is an impurity phase, in forming a PZT thin film by sputtering, without using a conventional seed layer.

### Solution to Problem

To achieve the above-described object, the present invention provides a PZT thin film laminate including: a semiconductor substrate; a platinum-adhesion layer formed of a titanium oxide and provided on the semiconductor substrate; a platinum electrode layer on the platinum-adhesion layer; a titanium thin film layer on the platinum electrode layer; and a PZT thin film layer on the titanium thin film layer.

The present invention is also effective when the titanium thin film layer has a thickness of 1 nm or more and 10 nm or less.

As another aspect, the present invention provides a PZT thin film laminate including: a semiconductor substrate; a platinum-adhesion layer formed of titanium and provided on the semiconductor substrate; a platinum layer provided on the platinum-adhesion layer; and a PZT thin film layer formed on the platinum layer.

The present invention is also effective when the platinum-adhesion layer formed of titanium has a thickness of 5 nm or more and 18 nm or less.

As a further aspect, the present invention provides a method of manufacturing a PZT thin film laminate, including: preparing a semiconductor substrate with a platinum-adhesion layer formed of a titanium oxide provided on the semiconductor substrate and with a platinum electrode layer provided on the platinum-adhesion layer; a first step of forming a titanium thin film layer by sputtering in a vacuum on the platinum electrode layer over the semiconductor substrate; and a second step of forming a PZT thin film layer on the titanium thin film layer by sputtering in a vacuum, wherein the semiconductor substrate with the titanium thin film layer formed is placed in a vacuum atmosphere between the first step and the second step. Advantageous Effects of Invention

The present invention described above prevents the generation of a pyrochlore phase, which is an impurity phase, in forming a PZT thin film by sputtering, without using a conventional seed layer.

Furthermore, the present invention improves the production efficiency of the PZT thin film laminate.

### Brief Description of Drawings

Fig. 1 is a cross-sectional view illustrating the configuration of a PZT thin film laminate according to an embodiment of the present invention.
Fig. 2 is a cross-sectional view illustrating the configuration of a PZT thin film laminate according to another embodiment of the present invention.
Figs. 3(a) to 3(c) illustrate the results of evaluation of the crystal orientation properties of PZT thin film layers of Examples 1 and 2 and Comparative Example 1 by an X-ray diffraction method.
Figs. 4(a) to 4(b) illustrate the results of evaluation of the crystal orientation properties of PZT thin film layers of Examples 1A and 1B and Examples 2A and 2B by an X-ray diffraction method.
Fig. 5 illustrates the evaluation results for electrical characteristics and piezoelectric characteristics obtained by forming a MIM structure using Pt as an upper electrode on the PZT thin film layer of Example 1 where a 1-nm-thick Ti thin film layer is formed on a Pt electrode layer.
Figs. 6(a) to 6(c) illustrate the results of evaluation of the crystal orientation properties of PZT thin film layers of Example 3 and Comparative Examples 2 and 3 by the X-ray diffraction method.
Figs. 7(a) to 7(f) illustrate the results of microstructural analysis of the PZT thin film layers of Example 3 and Comparative Examples 2 and 3 by SEM observation.
Fig. 8 illustrate the evaluation results for electrical characteristics and piezoelectric characteristics obtained by forming a MIM structure using Pt as an upper electrode on the PZT thin film layer of each of Example 3 and Comparative Examples 2 and 3.
Fig. 9 is a diagram for explaining the formation of PTO on a Pt nanofacet.

### Description of Embodiments

Embodiments of the present invention will now be described with reference to the drawings.

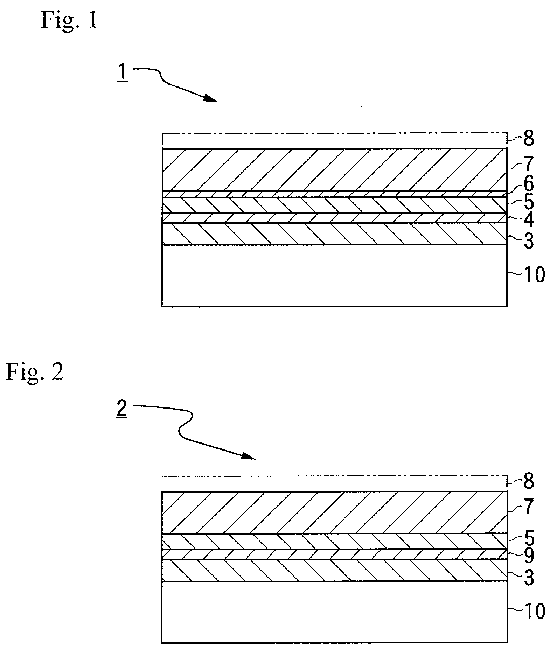

Fig. 1 is a cross-sectional view illustrating the configuration of a PZT thin film laminate according to an embodiment of the present invention.

As illustrated in Fig. 1, the PZT thin film laminate 1 according to the present embodiment includes a semiconductor substrate 10, which is, for example, a Si substrate.

The PZT thin film laminate 1 further includes: a silicon oxide (SiO₂) layer (hereinafter referred to as "SiO₂ layer") 3 on the Si substrate 10; a titanium oxide (TiOx) layer (hereinafter referred to as "TiOx layer") 4 serving as a platinum (Pt)-adhesion layer on the SiO₂ layer 3; an electrode layer formed of platinum (Pt) (hereinafter referred to as "Pt electrode layer") 5 on the TiOx layer 4; a thin film layer formed of titanium (Ti) (hereinafter referred to as "Ti thin film layer") 6 on the Pt electrode layer 5; and a PZT thin film layer 7 on the Ti thin film layer 6.

It should be noted that the Pt electrode layer 5 functions as a lower electrode layer when the device is constructed. In such a case, an upper electrode layer 8 is provided on the PZT thin film layer 7.

In the present embodiment, the Ti thin film layer 6 is formed, in place of a conventional seed layer, between the Pt electrode layer 5 and the PZT thin film layer 7.

The Ti thin film layer 6 preferably has a thickness of 1 nm or more and 10 nm or less.

If the thickness of the Ti thin film layer 6 is less than 1 nm, it is difficult to prevent the generation of a pyrochlore phase and to satisfactorily achieve (001)/(100) orientation of the PZT thin film.

On the other hand, if the thickness of the Ti thin film layer 6 exceeds 10 nm, the crystallinity of PZT deteriorates.

In the present invention, the method of forming the Ti thin film layer 6 is not limited to a particular method; however, it is preferable to employ a sputtering method from the viewpoint of improving production efficiency and ensuring uniformity of film thickness and film quality.

In this case, it is preferable to use a film-forming apparatus that allows for sputtering at a low pressure (< 1 Pa) and gas evacuation at a high vacuum (< 1E-4 Pa) from the viewpoint of achieving high crystallinity of Ti and preventing formation of oxides.

The PZT thin film layer 7 can be formed by an RF sputtering method.

In this case, the substrate is heated to have a temperature of 600°C during the sputtering.

Also, when forming the PZT thin film layer 7 after the formation of the Ti thin film layer 6, the Si substrate 10 with the Ti thin film layer 6 formed is preferably placed in a vacuum atmosphere.

This inhibits oxidation of the Ti thin film layer 6 and prevents deterioration of the crystal orientation properties of the PZT thin film layer 7.

Fig. 2 is a cross-sectional view illustrating the configuration of a PZT thin film laminate according to another embodiment of the present invention. In the drawing, parts common to those of the foregoing embodiment are assigned with identical reference numbers, and a detailed description thereof will be omitted.

As illustrated in Fig. 2, the PZT thin film laminate 2 according to the present embodiment includes: a Si substrate 10; an SiO₂ layer 3 on the Si substrate 10; a platinum-adhesion layer (hereinafter referred to as "Ti thin film adhesion layer") 9 formed of a titanium (Ti) thin film on the SiO₂ layer 3; a Pt electrode layer 5 on the Ti thin film adhesion layer 9; and a PZT thin film layer 7 on the Pt electrode layer 5.

In the present embodiment, the Ti thin film adhesion layer 9 is formed as a platinum-adhesion layer in place of the TiOx layer 4 illustrated in Fig. 1, and the PZT thin film layer 7 is formed directly on the Pt electrode layer 5.

The Ti thin film adhesion layer 9 is preferably formed to have a thickness of 5 nm or more and 18 nm or less.

If the thickness of the Ti thin film adhesion layer 9 is less than 5 nm, it is difficult to prevent the generation of a pyrochlore phase and to satisfactorily achieve the (001)/(100) orientation of the PZT thin film.

On the other hand, if the thickness of the Ti thin film adhesion layer 9 exceeds 18 nm, the crystallinity of PZT deteriorates.

In the present invention, the method of forming the Ti thin film adhesion layer 9 is not limited to a particular method; however, it is preferable to employ a sputtering method from the viewpoint of improving production efficiency and ensuring uniformity of film thickness and film quality.

In this case, it is preferable to perform sputtering at a low pressure (< 1 Pa) from the viewpoint of achieving high crystallinity of Ti.

### [Examples]

Examples and Comparative Examples of the present invention will now be described.

### [Example 1]

### <Formation of Ti thin film layer>

A first substrate for evaluation was prepared by forming a 0.1-µm-thick SiO₂ layer on a Si substrate having a diameter of 8 inches, a 0.03-µm-thick TiOₓ layer serving as a platinum-adhesion layer on the SiO₂ layer, and a 0.1-µm-thick Pt electrode layer on the TiOₓ layer.

Using the first substrate for evaluation, a 1-nm-thick Ti thin film layer was formed on the Pt electrode layer by a DC sputtering method.

In this process, a Ti target was used as a sputtering target, an argon gas was used as a sputtering gas, the pressure thereof was set at 0.16 Pa, and the temperature of the substrate was set at 25°C.

### <Formation of PZT thin film layer>

The substrate with the 1-nm-thick Ti thin film layer formed on the Pt electrode layer was placed in a vacuum atmosphere, and then a 2-µm-thick PZT thin film layer was formed on the Ti thin film layer by an RF magnetron sputtering method.

In this process, a target containing a 30% excess amount of Pb (Pb1.3Zr0.52Ti0.48O₃) manufactured by Ulvac Materials Division of Ulvac, Inc. was used as a sputtering target. Also, a module for dielectric of a sputtering apparatus (SME-200 and SME-200E manufactured by Ulvac, Inc.) was used.

As the film-forming condition for the PZT thin film layer, an argon gas was used as a sputtering gas, the pressure thereof was set at 0.5 Pa, and the temperature of the substrate was set at 600°C.

### [Example 2]

The TiOₓ layer serving as a platinum-adhesion layer in the first substrate for evaluation was replaced with a 5-nm-thick Ti thin film adhesion layer to provide a second substrate for evaluation. Using the second substrate for evaluation, a 2-µm-thick PZT thin film layer was formed directly on the Pt electrode layer under the same film-forming condition as that in Example 1.

The Ti thin film adhesion layer was formed by a DC sputtering method.

In this process, a Ti target was used as a sputtering target, an argon gas was used as a sputtering gas, the pressure thereof was set at 0.16 Pa, and the temperature of the substrate was set at 25°C.

### [Comparative Example 1]

Using the first substrate for evaluation described above, a 2-µm-thick PZT thin film layer was formed directly on the Pt electrode layer by the RF magnetron sputtering method.

In this process, the same film-forming condition as that in Example 1 was employed.

### <Evaluation results for crystal orientation properties of PZT thin film layer>

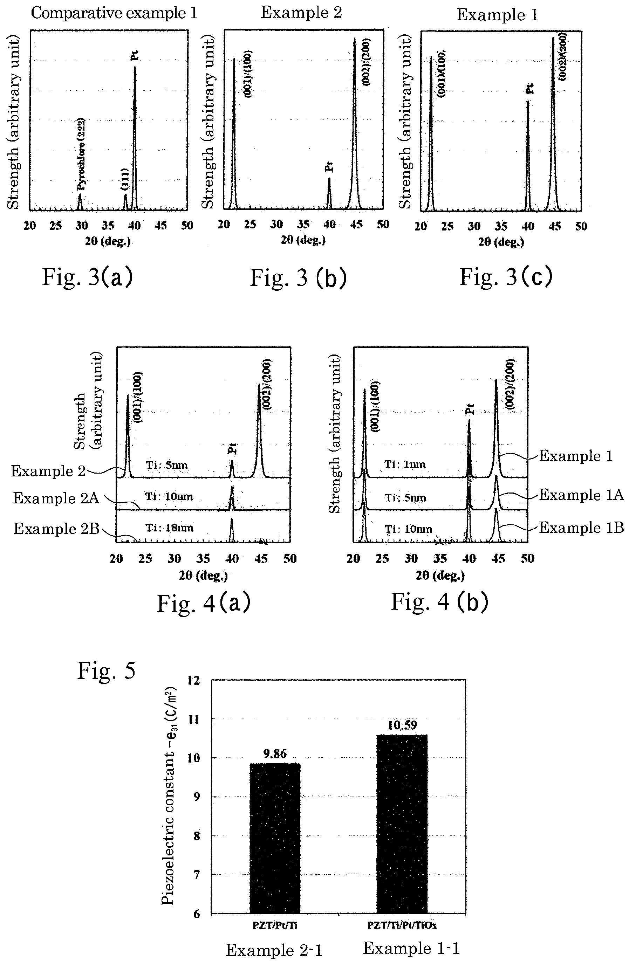

The PZT thin film layers formed in Examples 1 and 2 and Comparative Example 1 were evaluated for crystal orientation properties by an X-ray diffraction method. The results are illustrated in Figs. 3(a) to 3(c).

As illustrated in Fig. 3(c), it is seen that the desired (001)/(100) orientation was obtained by Example 1 in which the 1-nm-thick Ti thin film layer was formed on the Pt electrode layer, and the 2-µm-thick PZT thin film layer was formed on the Ti thin film layer.

Further, Example 1 showed no generation of a pyrochlore phase, which is an impurity phase.

As illustrated in Fig. 3(b), the desired (001)/(100) orientation was obtained also by Example 2 in which the 5-nm-thick Ti thin film adhesion layer was provided in place of the TiOₓ layer serving as a platinum-adhesion layer. It is also seen that no generation of a pyrochlore phase (i.e., an impurity phase) was observed for Example 2.

In contrast, as illustrated in Fig. 3(a), Comparative Example 1 in which the 2-µm-thick PZT thin film layer was formed directly on the Pt electrode layer showed a (111) orientation of PZT, and also a pyrochlore phase, which is an impurity phase.

The pyrochlore phase is a paraelectric body, and the presence of the pyrochlore phase in a PZT thin film layer leads to deterioration of the piezoelectric properties.

This phenomenon can be considered as follows.

It is considered that when the PZT thin film layer was formed directly on the Pt electrode layer, re-evaporation of PbO and diffusion of Pb into the Pt electrode layer occurred to cause Pb to become deficient in a sputtering initial layer, which led to the generation of a pyrochlore phase.

PtPbₓ alloy is known to be formed even at low temperatures, and is expected to be easily formed at 600°C, which is the film-forming temperature of the PZT thin film layer.

In the embodiment, a target containing a 30% excess amount of Pb is used in the expectation of a re-evaporation of PbO in the course of film formation. However, diffusion of PbO occurring at the interface of the Pt electrode layer is considered to have resulted in the Pb deficiency.

If the amount of Pb in the target is further increased, Pb in the PZT thin film layer becomes excessive, possibly leading to an increase in the leak current level and reduction in the dielectric strength voltage.

In contrast to this, for Example 1 having the Ti thin film layer on the Pt electrode layer, it is considered that the sputtered Pb and O particles and the Ti atoms on the Pt electrode layer reacted with each other to form PTO with the Ti atoms as a nucleus prior to the diffusion of Pb into the Pt electrode layer, and the generation of a pyrochlore phase was thereby prevented.

On the other hand, Example 2 takes advantage of the fact that Ti atoms easily diffuse in Pt. More specifically, it is considered that Ti atoms in the Ti thin film adhesion layer serving as the underlayer for the Pt electrode layer move through the Pt electrode layer and diffuse to the surface during the formation of the Pt electrode layer or during heating of the substrate before the formation of the PZT thin film layer, and those Ti atoms contribute to the reaction with the sputtered Pb and O particles.

Takahara et al. reported that forming a film of SrTiO₃ with a thickness of 5 nm on a Pt electrode prevented diffusion of Pb into the Pt electrode (see Thin Solid Films, 516 (2008) 8393).

### <Dependence of crystal orientation properties of PZT thin film layer on thickness>

### [Example 1A]

A PZT thin film layer was formed under the same condition as that in Example 1, except that the thickness of the Ti thin film layer on the Pt electrode layer was 5 nm.

### [Example 1B]

A PZT thin film layer was formed under the same condition as that in Example 1, except that the thickness of the Ti thin film layer on the Pt electrode layer was 10 nm.

### [Example 2A]

A PZT thin film layer was formed under the same condition as that in Example 2, except that the thickness of the Ti thin film adhesion layer was 10 nm.

### [Example 2B]

A PZT thin film layer was formed under the same condition as that in Example 2, except that the thickness of the Ti thin film adhesion layer was 18 nm.

### <Evaluation results>

The PZT thin film layers of Examples 1A and 1B and Examples 2A and 2B were evaluated for crystal orientation properties by an X-ray diffraction method. The results are illustrated in Figs. 4(a) and 4(b).

As illustrated in Figs. 4(a) and 4(b), even when the film thicknesses in Examples 1 and 2 were increased like those in Examples 1A and 1B and Examples 2A and 2B, the (001)/(100) orientation of PZT was achieved in all cases without the generation of a pyrochlore phase.

As a result, it was confirmed that in the case of forming the Ti thin film layer on the Pt electrode layer in the present invention, the Ti thin film layer can have a thickness of 1 nm or more and 10 nm or less.

In this case, regarding an optimum thickness of the Ti thin film layer, it was confirmed that the most favorable crystal orientation properties were obtained by Example 1 where the thickness of the Ti thin film layer on the Pt electrode was 1 nm.

On the other hand, it was confirmed that in the case of forming the Ti thin film adhesion layer in the present invention, the Ti thin film adhesion layer can have a thickness of 5 nm or more and 18 nm or less.

### <Evaluation of PZT thin film layer for electrical characteristics and piezoelectric characteristics >

### [Example 1-1]

A MIM (metal-insulator-metal) structure using Pt as an upper electrode layer was formed on the PZT thin film layer of Example 1 where the 1-nm-thick Ti thin film layer was formed on the Pt electrode layer, and the resulting structure was evaluated for electrical characteristics and piezoelectric characteristics. The result is illustrated in Fig. 5.

### [Example 2-1]

A MIM structure using Pt as an upper electrode layer was formed on the PZT thin film of Example 2 where the 5-nm-thick Ti thin film adhesion layer was provided as a platinum-adhesion layer, and the resulting structure was evaluated for electrical characteristics and piezoelectric characteristics. The result is illustrated in Fig. 5.

As illustrated in Fig. 5, Example 1-1 including the Ti thin film layer of the smallest thickness, i.e., 1 nm, on the Pt electrode layer had a larger piezoelectric constant than that of Example 2-1 including the Ti thin film adhesion layer serving as a platinum-adhesion layer of the smallest thickness (i.e., 5 nm).

The above results confirmed that better piezoelectric characteristics are obtained by forming the Ti thin film layer on the Pt electrode layer than in the case of forming the Ti thin film adhesion layer as a platinum-adhesion layer.

### <Relationship between oxidation state of Ti thin film layer and crystal orientation properties of PZT thin film layer>

From the viewpoint of improving production technology, experiments were performed with various oxidation states of the Ti thin film layer formed on the Pt electrode layer.

This was intended to obtain data related to the configuration of the apparatus, such as whether or not consecutive vacuum conveyance is necessary between a film-forming chamber for forming the Ti thin film layer and a film-forming chamber for forming the PZT thin film layer.

### [Example 3]

In a first vacuum chamber, a 1-nm-thick Ti thin film layer was formed on a Pt electrode layer under the same condition as that in Example 1. Immediately thereafter, the substrate was conveyed in a vacuum atmosphere to a second vacuum chamber. In the second vacuum chamber, a 2-µm-thick PZT thin film layer was formed on the Ti thin film layer under the same condition as that in Example 1.

### [Comparative Example 2]

A 1-nm-thick Ti thin film layer was formed on a Pt electrode layer in a vacuum under the same condition as that in Example 1; and then, the substrate was exposed to the atmosphere for one hour.

Thereafter, a 2-µm-thick PZT thin film layer was formed on the Ti thin film layer in a vacuum under the same condition as that in Example 1.

### [Comparative Example 3]

A 1-nm-thick Ti thin film layer was formed on a Pt electrode layer in a vacuum under the same condition as that in Example 1; and then, annealing was performed at a temperature of 750°C in an oxygen atmosphere for one minute.

Thereafter, a 2-µm-thick PZT thin film layer was formed on the Ti thin film layer in a vacuum under the same condition as that in Example 1.

### <Evaluation results for crystal orientation properties>

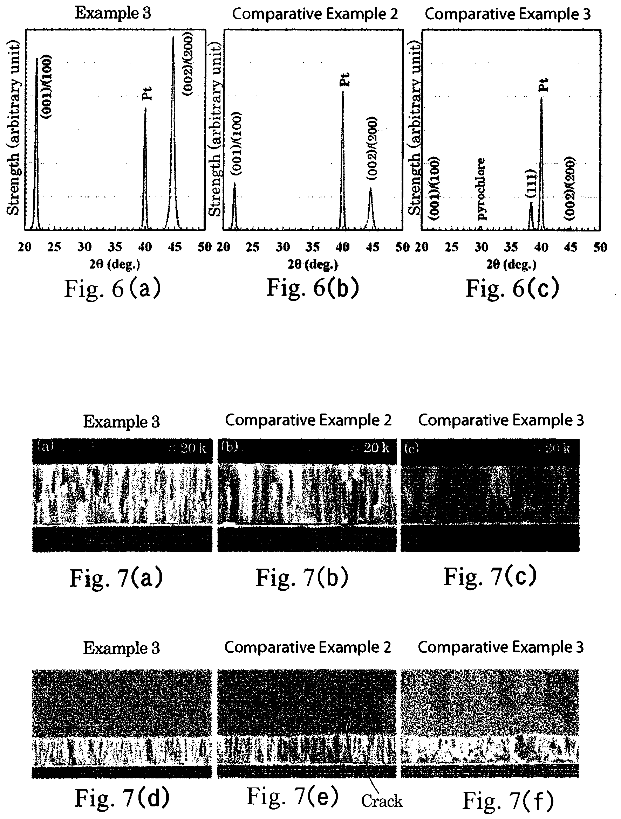

The PZT thin film layers of Example 3 and Comparative Examples 2 and 3 were evaluated for crystal orientation properties by the X-ray diffraction method. The results are illustrated in Figs. 6(a) to 6(c).

Also, the PZT thin film layers of Example 3 and Comparative Examples 2 and 3 were subjected to microstructural analysis by SEM observation. The results are illustrated in Figs. 7(a) to 7(f).

As illustrated in Fig. 6(a), Example 3 in which the formation of the Ti thin film layer on the Pt electrode layer and the formation of the PZT thin film layer on the Ti thin film layer were performed consecutively, both in a vacuum, exhibited favorable crystal orientation properties of the PZT thin film layer like in Example 1, as described above.

On the other hand, as illustrated in Fig. 6(b), Comparative Example 2, in which the Ti thin film layer was formed on the Pt electrode layer in a vacuum and thereafter the substrate was exposed to the atmosphere for one hour, showed a decrease in the strength of the (001)/(100) orientation.

The reason for this is considered to be that since a Ti thin film with a thickness of 5 nm or less generally has a large surface area and high reactivity, such a Ti thin film is naturally oxidized in the atmosphere, resulting in the deterioration of the crystal orientation properties of the PZT thin film.

As illustrated in Fig. 6(c), for Comparative Example 3, in which the Ti thin film layer was formed on the Pt electrode layer in a vacuum and thereafter annealing was performed at a temperature of 750°C in an oxygen atmosphere for one minute, the generation of a pyrochlore phase was confirmed and also a (111) orientation of PZT was confirmed.

This result indicates a tendency similar to Comparative Example 1 in which the PZT thin film layer was formed directly on the Pt electrode layer (see Fig. 3(a)).

The reason for this is considered to be as follows. When Pb deficiency occurs at the interface of the Pt electrode layer, a pyrochlore phase is generated and at the same time, TiOₓ is generated at the interface of the Pt electrode layer. This is considered to have caused the (111) orientation of PZT (see Journal of Applied Physics, 100 (2006) 051605).

On the other hand, as illustrated in Fig. 7(e), for Comparative Example 2, in which exposure to the atmosphere was performed after the formation of the Ti thin film layer on the Pt electrode layer, cracks was observed in the surface of the PZT thin film layer.

The reason for this is considered to be as follows. A high H₂O partial pressure during the formation of a PZT thin film sometimes causes peeling of the film attributable to hydrogen (H). A phenomenon similar to this presumably occurred by the generation of hydroxides on the surface of the Ti thin film layer when exposed to the atmosphere.

Furthermore, as illustrated in Figs. 7(c)and 7(f), for Comparative Example 3, in which annealing was performed after the Ti thin film layer was formed on the Pt electrode layer, crystallinity and orientation properties were totally different from those of Example 3. The differences are also apparent from the microstructure.

In this respect, the inventors' past experiments also clarified that the generation of a pyrochlore phase or a (111) orientation makes the columnar structure larger.

### <Relationship between oxidation state of Ti thin film layer and electrical characteristics and piezoelectric characteristics of PZT thin film layer>

### [Example 3-1, Comparative Example 2-1 and Comparative Example 3-1]

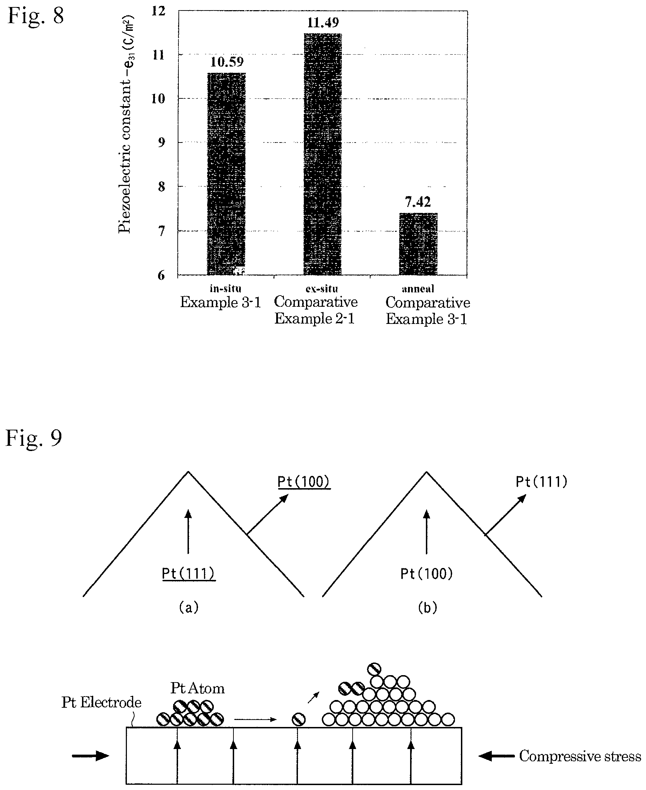

A MIM structure using Pt as an upper electrode layer was formed on the PZT thin film layer of each of Example 3 and Comparative Examples 2 and 3, and the resulting structure was evaluated for electrical characteristics and piezoelectric characteristics. The results are illustrated in Fig. 8.

As illustrated in Fig. 8, Comparative Example 2-1, in which exposure to the atmosphere was performed after the formation of the Ti thin film layer, was larger in piezoelectric constant -e₃₁ than in Example 3-1, in which the formation of the PZT thin film on the Ti thin film layer was performed in a vacuum. This is due to cracks being generated in the film to reduce the mechanical rigidity, thus making the film easily deformable.

A film with cracks is not preferable because it may be insufficient in terms of mechanical stability or may cause peeling of a PZT film from an electrode.

As described above, it was confirmed that inhibition of the generation of a pyrochlore phase and control of crystal orientation, which are significant challenges in the formation of a PZT thin film by sputtering, are enabled by the present invention.

Further, as clearly seen from the results for Example 1 and Example 3, in particular, generation of a pyrochlore phase was prevented and a PZT thin film layer having a (001)/(100) single orientation was obtained by forming the 1-nm-thick Ti thin film layer on the Pt electrode layer.

This is due to PTO being generated at the interface of the Pt electrode layer by consecutively forming the Ti thin film layer and the PZT thin film layer on the Pt electrode layer in a vacuum.

In this regard, Muralt et al. point out that PTO having a small critical radius is formed during the initial nucleus formation of PZT, and subsequently, PZO is solid-dissolved with the PTO to form PZT (see Journal of Applied Physics, 100 (2006) 051605).

Based on this, it follows that PTO is not detected at the interface between the Pt electrode layer and PZT in the PZT thin films obtained in the Examples described herein.

Here, one question remains. The question is why a film having (001)/(100) orientation is obtained when PTO is generated by consecutive film formation in a vacuum.

In this regard, Muralt et al. calculated the frequency of the nucleus generation of PTO on a Pt electrode layer (see Table 1). It is understood that in PTO (100) compared to PTO (111), both the critical radius and the energy barrier of nucleus formation are superior.

**[Table 1]**

| Crystal Plane Azimuth and Nucleus Generation of PTO on Pt Electrode | | |
|---|---|---|
| T = 873k | PTO (100) | PTO (111) |
| Critical radius r*(nm) | 1.4 (8 unit) | 2.1 (11 unit) |
| Energy barrier G* (eV) | 1.74 | 2.17 |
| Frequency of nucleus generation I(1/s µm²) on Pt | 4.2 × 10³ | 13 |

Here, most noteworthy is the frequency of nucleus generation.

Table 1 indicates that the frequency of nucleus generation of the (100) plane in PTO is approximately 300 times higher than that of the (111) plane.

Further, Matsuo et al. discuss the crystal orientation of PTO, focusing attention on the nanofacet of the Pt surface (see Fig. 9).

It is known that Pt is usually self-oriented to (111) having a small surface energy. The Pt electrode layer formed by the present inventors also has (111) single orientation.

Many nanofacets exist on the surface of the Pt electrode layer; and the nanofacet of a film that is (111)-oriented to the out-of-plane of the substrate is the (100) plane (see Fig. 9(a). (Fig. 9(b) is provided for comparison).

It is considered that the present invention is based on such an orientation mechanism with PTO being (100)-oriented to this nanofacet.

According to the present invention described above, since the Ti thin film layer and the PZT thin film layer are formed consecutively on the Pt electrode layer in a vacuum, production efficiency of the PZT thin film laminate is improved.

### Reference Numbers List

- 1: PZT thin film laminate
- 2: PZT thin film laminate
- 3: SiO₂ layer
- 4: TiO_{X} layer
- 5: Pt electrode layer
- 6: Ti thin film layer
- 7: PZT thin film layer
- 9: Ti thin film adhesion layer
- 10: Si substrate (semiconductor substrate)

## Claims

1. A PZT thin film laminate, comprising:
a semiconductor substrate;
a platinum-adhesion layer formed of a titanium oxide and provided on the semiconductor substrate;
a platinum electrode layer on the platinum-adhesion layer;
a titanium thin film layer on the platinum electrode layer; and
a PZT thin film layer on the titanium thin film layer.

2. The PZT thin film laminate according to claim 1, wherein the titanium thin film layer has a thickness of 1 nm or more and 10 nm or less.

3. A PZT thin film laminate, comprising: a semiconductor substrate;
a platinum-adhesion layer formed of titanium and provided on the semiconductor substrate;
a platinum layer on the platinum-adhesion layer; and
a PZT thin film layer on the platinum layer.

4. The PZT thin film laminate according to claim 3, wherein the platinum-adhesion layer formed of titanium has a thickness of 5 nm or more and 18 nm or less.

5. A method of manufacturing a PZT thin film laminate, comprising:
preparing a semiconductor substrate with a platinum-adhesion layer formed of a titanium oxide provided on the semiconductor substrate and with a platinum electrode layer provided on the platinum-adhesion layer;
a first step of forming a titanium thin film layer by sputtering in a vacuum on the platinum electrode layer over the semiconductor substrate; and
a second step of forming a PZT thin film layer on the titanium thin film layer by sputtering in a vacuum,
wherein the semiconductor substrate with the titanium thin film layer formed is placed in a vacuum atmosphere between the first step and the second step.
